Europäisches Patentamt

European Patent Office

Office européen des brevets

(19)

(11) **EP 0 711 100 B1**

(12) **FASCICULE DE BREVET EUROPEEN**

(45) Date de publication et mention
de la délivrance du brevet:
**13.01.1999 Bulletin 1999/02**

(51) Int Cl.6: **H05H 1/46**, H01J 37/32

(21) Numéro de dépôt: **95420289.1**

(22) Date de dépôt: **20.10.1995**

(54) **Dispositif de production d'un plasma permettant une dissociation entre les zones de propagation et d'absorption des micro-ondes**

Plasmaerzeugungsvorrichtung, ermöglichend eine Trennung zwischen Mikrowellenübertragung und -absorptionszonen

Plasma production device, allowing a dissociation between microwave propagation and absorption zones

(84) Etats contractants désignés:
**BE CH DE FR GB IT LI NL**

(30) Priorité: **04.11.1994 FR 9413499**

(43) Date de publication de la demande:
**08.05.1996 Bulletin 1996/19**

(73) Titulaire: **METAL PROCESS,
Société à Responsabilité Limiteé:
77144 Montevrain (FR)**

(72) Inventeur: **Pelletier, Jacques Henri Lucien
F-38400 Saint Martin d'Heres (FR)**

(74) Mandataire: **Thibault, Jean-Marc
Cabinet Beau de Loménie
51, Avenue Jean Jaurès
B.P. 7073
69301 Lyon Cédex 07 (FR)**

(56) Documents cités:
**EP-A- 0 209 469          EP-A- 0 402 282
EP-A- 0 496 681          EP-A- 0 613 329**

**Description**

La présente invention concerne le domaine technique général de la production de plasma par micro-ondes à partir d'un milieu gazeux de toute nature.

L'invention vise, plus précisément, le domaine de la production de plasma par micro-ondes, soit en champ magnétique à la résonance cyclotronique électronique, soit en l'absence de champ magnétique pour des plasmas à haute pression.

L'objet de l'invention trouve des applications particulièrement avantageuses dans le domaine des traitements de surfaces (gravure, dépôt, nettoyage, désinfection, décontamination, pulvérisation, implantation ionique, traitement chimique ou thermochimique) ou de la production de faisceaux d'ions obtenus par extraction du plasma ou, d'une manière générale, en vue de toute autre application où la production de plasma dense est requise.

Il est connu dans l'état de la technique de nombreux dispositifs de production de plasma. Par exemple, le brevet français FR-A-2583250 (EP-A- 0 209 469) décrit une technique d'excitation de plasma à la résonance cyclotronique électronique. La résonance cyclotronique électronique est obtenue lorsque la fréquence de giration d'un électron, dans un champ magnétique statique ou quasi-statique, est égale à la fréquence du champ électrique accélérateur appliqué. La résonance est obtenue pour un champ magnétique $\mathbf{B}$ et une fréquence d'excitation $\mathbf{f}$ liée par la relation :

$$B = (2\pi mf) / e$$

où $\mathbf{m}$ et $\mathbf{e}$ sont respectivement la masse et la charge de l'électron. A titre d'exemple, pour une fréquence de 2,45 GHz, un champ magnétique de 0,0875 Tesla est nécessaire pour obtenir la résonance.

Dans le cas de l'excitation d'un plasma, la résonance cyclotronique électronique n'est possible que si l'électron peut être suffisamment accéléré par ce processus, c'est-à-dire si l'électron peut tourner suffisamment longtemps en phase avec le champ électrique pour acquérir l'énergie de seuil nécessaire à l'ionisation du gaz. Pour ce faire, il faut, d'une part, que le rayon de giration soit suffisamment petit, en particulier, pour rester dans la région de l'espace réunissant les conditions de résonance, c'est-à-dire de présence simultanée du champ électrique appliqué et du champ magnétique d'intensité $\mathbf{B}$ et, d'autre part, que la fréquence de giration reste grande devant la fréquence des collisions élastiques des électrons sur les éléments neutres, à savoir atomes et/ou molécules. Autrement dit, les meilleurs conditions d'excitation d'un plasma à la résonance cyclotronique électronique sont obtenues à la fois pour une pression de gaz suffisamment faible et une fréquence de champ électrique $\mathbf{f}$ élevée, c'est-à-dire aussi pour une intensité de champ magnétique $\mathbf{B}$ élevée. En pratique, dans un plasma conventionnel, les conditions favorables à une excitation à la résonance cyclotronique électronique sont obtenues pour des fréquences $\mathbf{f}$ de l'ordre ou supérieures à 500 MHz et des pressions de gaz de l'ordre de $10^{-1}$ Pascal, typiquement de $10^{-3}$ à 10 Pascals suivant la nature du gaz. Toutefois, les fréquences micro-onde supérieures à 10 GHz nécessitent des intensités de champ magnétique très élevées qu'il n'est pas possible d'obtenir avec des aimants permanents et des structures magnétiques conventionnelles. A la fréquence $\mathbf{f}$ = 2,45 GHz, l'intensité $\mathbf{B}$ vaut 0,0875 Tesla et dépasse 0,35 Tesla à la fréquence $\mathbf{f}$ = 10 GHz.

La technique décrite dans ce brevet français cité ci-dessus nécessite, tel que cela apparaît plus précisément à la **fig. 1**, la mise en oeuvre d'aimants permanents **1** créant chacun au moins une surface **2** à champ magnétique constant et d'intensité correspondant à la résonance cyclotronique électronique. La puissance électromagnétique est amenée au niveau de la zone de résonance **2** par l'intermédiaire d'antennes **3** ou d'excitateurs de plasma constitués chacun par un élément filaire métallique. Chaque excitateur **3** est disposé au droit des aimants permanents **1** qui sont montés sur la paroi d'une enceinte étanche **4**.

Le champ magnétique d'intensité égale à la valeur donnant la résonance et le champ électromagnétique sont tous les deux localisés et confinés essentiellement dans l'espace situé entre un excitateur **3** et la partie de la paroi de l'enceinte placée en vis-à-vis d'un aimant. En présence d'un milieu gazeux présentant une pression réduite, les électrons sont accélérés dans la zone de résonance et s'enroulent le long des lignes de champ magnétique **5** qui définissent une surface de confinement du plasma. Ces lignes de champ **5**, en forme de festons, relient le pôle d'un aimant aux pôles des aimants adjacents. Le long de son trajet, l'électron dissocie et ionise les molécules et les atomes avec lesquels il entre en collision. Le plasma est alors produit le long des lignes de champ et diffuse, ensuite, à partir de ces lignes de champ, pour former un plasma froid pratiquement exempt des électrons énergétiques qui restent piégés dans les festons. Un inconvénient majeur d'un tel dispositif est que la propagation de l'énergie micro-onde et la zone de résonance où l'énergie micro-onde est absorbée, se superposent. Il ne peut donc y avoir propagation des micro-ondes le long de l'applicateur filaire sans une absorption simultanée. L'intensité du champ électrique micro-onde et la densité du plasma diminuent donc toutes les deux progressivement le long de l'antenne. Il est ainsi obtenu un plasma qui, le long de l'antenne, présente une densité non uniforme, inadaptée par conséquent à la plupart des applications industrielles.

Pour remédier à cet inconvénient, le brevet FR-A- 2 671 931 (EP-A- 0 496 681 propose de placer l'antenne **3** dans une zone inter-aimant **6** comprise entre la paroi de l'enceinte et les lignes de champ magnétique **5** qui relient deux pôles adjacents de polarités différentes.

Cette zone **6** est particulièrement propice à la propagation des micro-ondes, car elle est pratiquement exempte de plasma, puisque la diffusion du plasma, normalement aux lignes de champ, est considérablement réduite lorsque l'intensité du champ magnétique augmente. Il est ainsi obtenu, tout le long de l'applicateur micro-onde, des ondes stationnaires d'amplitude constante avec toutes les demi-longueurs d'ondes, des minima et des maxima de puissance micro-onde. Cependant, même si la puissance micro-onde, le long des applicateurs, se trouve répartie uniformément en moyenne, le terme source de plasma est en fait rendu uniforme en raison de l'existence d'une dérive des électrons le long des applicateurs due au gradient et à la courbure du champ magnétique proche des applicateurs de champ magnétique. Un plasma uniforme peut alors être produit le long de l'applicateur.

Un inconvénient majeur de cette technique est que les zones où le champ électrique micro-onde est maximum, c'est-à-dire entre l'applicateur et la paroi de l'enceinte, et les zones de résonance où l'intensité du champ magnétique est égale à la résonance cyclotronique électronique, ne coïncident pas. Pour produire l'excitation du plasma, il convient, soit d'accroître l'intensité du champ électrique micro-onde appliqué, soit d'accroître l'intensité du champ magnétique pour étendre la zone de résonance. Dans ce dernier cas, il est nécessaire d'utiliser des aimants permanents pouvant délivrer des intensités de champ magnétique très élevées dépassant très nettement les simples conditions de résonance.

En outre, l'ensemble des techniques décrites par les deux précédents brevets présentent, par ailleurs, les inconvénients suivants :

- un faible pourcentage de volume utile de champ magnétique produit par les aimants permanents,
- la nécessité de positionner très précisément les applicateurs micro-onde par rapport aux aimants,
- l'obligation de réaliser les parois de la chambre avec une faible épaisseur, compte-tenu de la décroissance très rapide de l'intensité du champ magnétique fonction de l'éloignement de la surface de l'aimant,
- la nécessité d'utiliser des applicateurs de champ magnétique capables de délivrer, le long de l'applicateur micro-onde, un champ magnétique ayant un caractère aussi uniforme que possible, afin d'éviter des ruptures d'impédance extrêmement défavorables à la propagation des micro-ondes le long de l'applicateur,
- la quasi impossibilité de pomper et de distribuer les gaz à travers la structure d'excitation du plasma,
- et un mauvais rendement d'excitation et une pulvérisation des parois due aux ions qui diffusent avec les électrons rapides qui créent le plasma et sont perdus sur les parois en raison de la dérive des électrons due au gradient et à la courbure du champ magnétique (effet magnétron).

L'objet de l'invention vise donc à remédier aux divers inconvénients des solutions techniques antérieures en proposant un dispositif adapté pour assurer la propagation et la répartition de la puissance micro-onde avec un minimum de pertes sur toute la longueur de l'applicateur de champ magnétique, de manière à obtenir une puissance micro-onde maximale autorisant une densité de plasma pratiquement constante au moins en moyenne.

L'objet de l'invention vise à offrir un dispositif de production de plasma adapté pour permettre une augmentation de la puissance micro-onde, sans limitation purement physique, permettant d'accroître simultanément la densité dudit plasma.

Pour atteindre ces objectifs, le dispositif de distribution d'une puissance micro-onde pour l'excitation d'un plasma à l'intérieur d'une enceinte, comporte :

- une source d'énergie micro-onde,
- au moins un premier applicateur d'une énergie micro-onde,
- et au moins un excitateur du plasma de forme filaire, placé à distance du premier applicateur micro-onde pour délimiter entre-eux une zone d'absorption, les électrons étant accélérés par le champ micro-onde selon des trajectoires déterminées.

Selon l'invention, le dispositif de distribution comporte au moins un second applicateur de l'énergie micro-onde pour former, avec un premier applicateur et un excitateur, au moins un triplet d'excitation dans lequel, d'une part, le premier applicateur et le second applicateur sont montés sensiblement parallèlement l'un de l'autre en étant écartés d'une mesure donnée pour délimiter entre-eux une zone de propagation de l'énergie micro-onde et, d'autre part, l'excitateur est disposé à l'intérieur de l'enceinte en étant placé par rapport aux premier et au second applicateurs, de manière que les trajectoires des électrons ne traversent pas la zone de propagation permettant d'obtenir une dissociation entre les zones de propagation et d'absorption.

Diverses autres caractéristiques ressortent de la description faite ci-dessous en référence aux dessins annexés qui montrent, à titre d'exemples non limitatifs, des formes de réalisation et de mise en oeuvre de l'objet de l'invention.

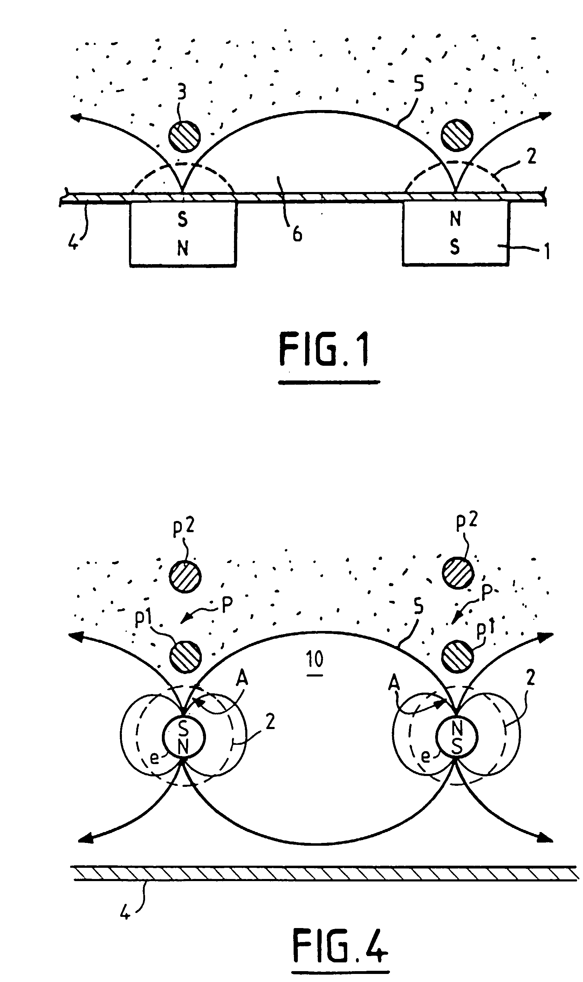

La **fig. 1** est une vue schématique en coupe d'un dispositif de l'art antérieur de répartition d'une énergie micro-onde.

La **fig. 2** montre, de façon schématique, une machine de production de plasma mettant en oeuvre un exemple de réalisation d'un dispositif de distribution d'une énergie micro-onde, conforme à l'invention.

La **fig. 3** est une vue en coupe prise sensiblement selon les lignes III-III de la **fig. 2**.

La **fig. 4** illustre, à plus grande échelle, un dispositif de distribution élémentaire conforme à l'invention.

La **fig. 5** illustre une forme de réalisation d'applicateurs d'excitation, susceptibles d'être mis en oeuvre dans le dispositif conforme à l'invention.

Les **fig. 6** à **8** montrent diverses combinaisons de mise en oeuvre du dispositif d'excitation selon l'invention.

Les **fig. 9** et **10** sont des vues schématiques illustrant le principe de mise en oeuvre du dispositif d'excitation selon l'invention, dans une seconde variante de réalisation.

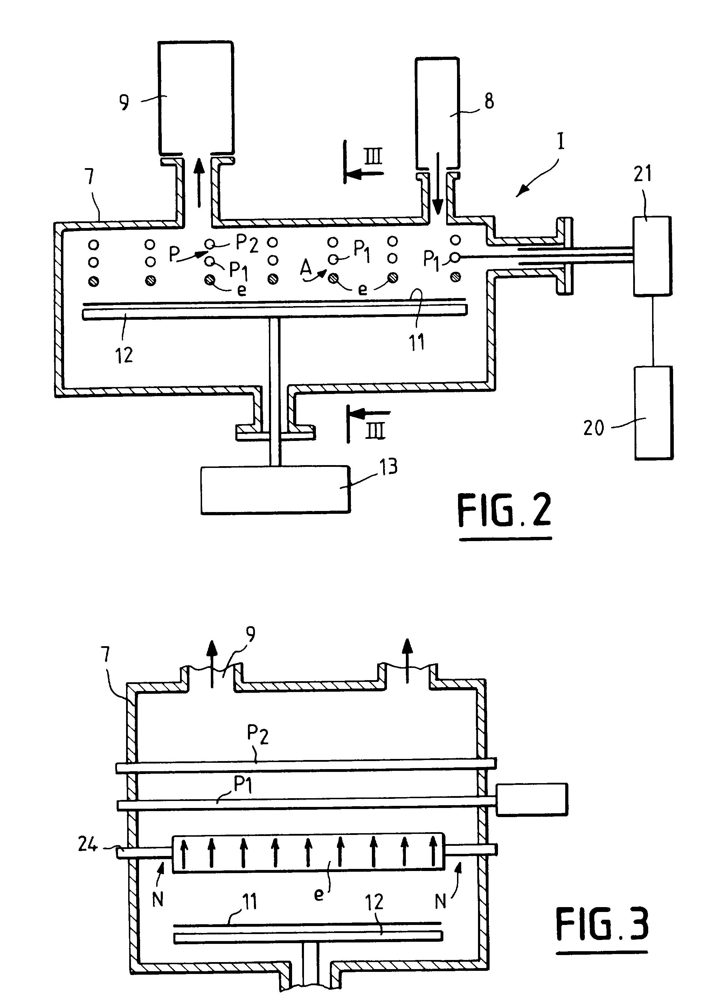

Tel que cela ressort des **fig. 2** et **3**, la machine **I** est adaptée pour assurer la production d'un plasma à partir de milieux gazeux de toute nature, en vue d'applications très diverses, telles que les traitements de surfaces ou la production de faisceaux d'ions. La machine comporte une enceinte étanche **7** amagnétique équipée d'au moins un dispositif **8** d'introduction de gaz et d'au moins un dispositif **9** de pompage de gaz permettant de maintenir à travers la zone d'excitation, la pression du gaz à ioniser à une valeur souhaitée qui peut être, par exemple, de l'ordre de $10^{-2}$ à quelques Pascals. La machine **I** comporte, également, un dispositif conforme à l'invention, d'excitation du plasma qui se trouve confiné dans une zone centrale de l'enceinte. Le plasma permet, dans la zone d'utilisation, par exemple un traitement de surface pour un échantillon ou produit **11** placé sur un support **12** et polarisé par rapport au potentiel plasma à l'aide d'un générateur **13**.

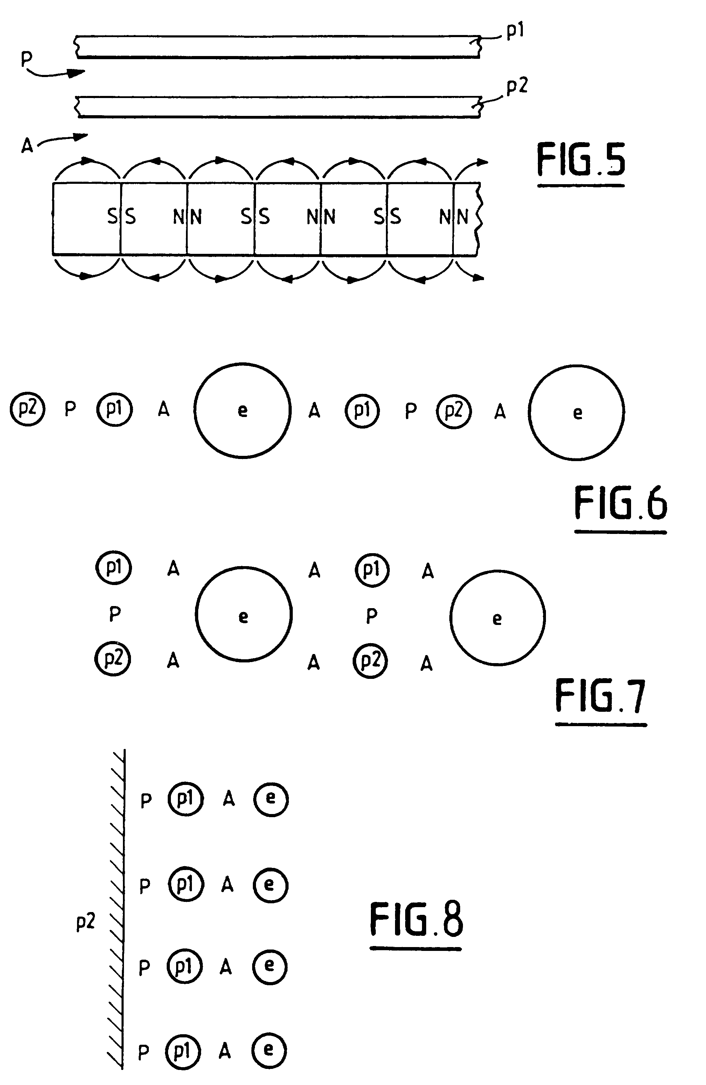

Le dispositif d'excitation selon l'invention comporte au moins un excitateur **e** de plasma constituant, dans une première variante de réalisation, un élément d'application d'un champ magnétique utilisant soit des courants électriques parcourant des conducteurs ou des supraconducteurs, soit des aimants permanents. Dans l'exemple illustré, le dispositif d'excitation comprend une série d'excitateurs **e** réalisés chacun par un aimant permanent présentant une forme filaire ou filiforme et formant ensemble une structure magnétique multipolaire. Tel que cela apparaît plus précisément aux **fig. 2** et **4**, les excitateurs magnétiques **e**, qui s'étendent sensiblement parallèlement entre-eux, présentent successivement au plasma, des polarités alternées, de façon à constituer une surface magnétique **5** se présentant sous la forme de festons de ligne de champ magnétique. Les excitateurs magnétiques **e** sont positionnés de manière que les lignes de champ magnétiques, en forme de festons, relient le pôle d'un aimant à son pôle opposé ou au pôle opposé d'un aimant consécutif. La production de plasma est ainsi confinée dans la zone **10** à l'intérieur des festons de ligne de champ magnétique **5**.

Dans un exemple préféré de réalisation, la structure magnétique multipolaire est réalisée de manière à obtenir un champ magnétique d'intensité suffisante pour assurer la résonance cyclotronique électronique. Tel que cela apparaît plus précisément à la **fig. 4**, chaque excitateur **e** est apte à créer une surface **2** à champ magnétique constant et d'intensité correspondant à la résonance cyclotronique électronique. Cette surface **2** enveloppe partiellement chaque aimant **e** ou totalement, comme représenté en pointillés sur la **fig. 4**. Par exemple, pour une fréquence d'excitation de 2,45 GHz, le champ magnétique doit être de 0,0875 Tesla et pour une fréquence d'excitation de 5,8 GHz, l'intensité du champ magnétique doit être de 0,207 Tesla.

Les excitateurs **e** sont placés à l'intérieur de l'enceinte **7**, à une distance donnée des parois de l'enceinte pour permettre, d'une part, le pompage des gaz à partir de ces parois et, d'autre part, aux électrons accélérés à la résonance cyclotronique électronique, d'osciller le long des lignes de champ magnétique et de dériver perpendiculairement au champ magnétique et au gradient ou courbure de champ magnétique. Les excitateurs **e** sont donc placés afin que les trajectoires des électrons qui s'enroulent sur les lignes de champ magnétique ne soient pas coupées par les parois de l'enceinte.

Le dispositif d'excitation conforme à l'invention comporte aussi au moins un, et dans l'exemple illustré, une série de premiers applicateurs $p_1$ d'une énergie dans le domaine des micro-ondes, positionnés dans une région localisée donnée. Les premiers applicateurs $p_1$ sont reliés, par tous moyens convenables, à un générateur **20** d'une énergie micro-onde par l'intermédiaire d'un adaptateur d'impédance **21**. Chaque premier applicateur $p_1$ est placé à une distance prédéterminée de l'excitateur **e** pour délimiter entre-eux une zone d'absorption **A**, dans laquelle se produit l'accélération des électrons. A cet effet, l'excitation du plasma requiert, dans cette zone d'absorption **A**, une accélération suffisante des électrons pour exciter le plasma et donc des intensités adéquates pour le champ électrique micro-onde et le champ magnétique. Les électrons ainsi accélérés produisent le plasma le long de leurs trajectoires qui suivent les lignes de champ **5**. Dans l'exemple illustré à la **fig. 4**, l'excitation du plasma s'effectue à la résonance cyclotronique électronique.

Chaque premier applicateur $p_1$ est, de préférence, réalisé par un élément filaire alimenté à l'une de ses extrémités, soit par un passage coaxial sous-vide, soit par une transition guide d'ondes-structure coaxiale, soit encore par une transition cavité-structure coaxiale. Dans le cas de réalisation du premier applicateur $p_1$ par un élément filaire, chaque zone d'absorption **A** est située le long de l'applicateur $p_1$, entre ce dernier et l'aimant **e** placé en correspondance.

Conformément à l'invention, le dispositif d'excitation comporte également au moins un, et dans l'exemple illustré, une série de seconds applicateurs $p_2$ de l'énergie micro-onde, placés chacun à une distance prédéterminée d'un premier applicateur $p_1$. Chaque second applicateur $p_2$ délimite ainsi, avec le premier applicateur $p_1$ placé à proximité, une zone **P** de propagation de la puissance micro-onde, dans la mesure où un couplage s'effectue entre les premier $p_1$ et second $p_2$ applicateurs voisins. Dans l'exemple illustré, chaque excitateur **e** est placé pour s'étendre sensiblement parallèlement aux applicateurs $p_1$, $p_2$. Il est à noter que l'excitateur $e$ peut être placé dans une position différente par rapport aux applicateurs $p_1$, $p_2$. Ainsi, l'excitateur $e$ peut être placé perpendiculairement aux applicateurs $p_1$, $p_2$. D'une manière plus générale, il peut être prévu de placer un réseau d'excitateurs $e$ perpendiculairement à un réseau d'applicateurs $p_1$, $p_2$. Le dispositif d'excitation selon l'invention comporte au moins un, et d'une manière générale, une série de triplets d'éléments d'excitation, composés chacun par un excitateur $e$, un premier applicateur $p_1$ et un second applicateur $p_2$. Dans chaque triplet, le second applicateur $p_2$ et le premier applicateur $p_1$ sont placés par rapport à l'excitateur $e$, de manière que les trajectoires des électrons énergétiques ne traversent pas la zone de propagation $P$ de la puissance micro-onde. En effet, d'une manière classique, les électrons énergétiques s'enroulent autour des lignes des champs magnétiques $5$. Les applicateurs $p_1$, $p_2$ de chaque triplet doivent donc être placés de façon que les trajectoires $5$ des électrons énergétiques ne traversent pas la zone de propagation $P$. De cette façon, il peut être obtenu une dissociation entre chaque zone de propagation $P$ et la zone d'absorption $A$ associée, permettant une bonne propagation de l'énergie micro-onde tout le long de l'excitateur.

Les excitateurs $e$ sont positionnés de telle façon que les trajectoires des électrons qui s'enroulent sur les lignes de champ magnétique ne rencontrent aucun obstacle ou se trouvent coupées notamment par les parois de l'enceinte. A cet effet, l'excitateur $e$ doit être situé à distance des parois de l'enceinte selon sa longueur et au niveau d'au moins l'une de ses parties terminales dans le cas notamment d'une aimantation diamétrale, comme illustrée à la **fig. 3**. Selon cette variante de réalisation, l'excitateur $e$ possède une longueur finie inférieure à la dimension de l'enceinte $7$ de façon à laisser subsister entre au moins une et, de préférence, les deux parties terminales de l'excitateur $e$ et les parois de l'enceinte $7$, une zone $N$ de non excitation. Pour des excitateurs $e$ de grande longueur, chaque aimant $e$ est prolongé à chacune de ses parties terminales, par un segment $24$ de montage sur les parois de l'enceinte.

Le montage de l'excitateur $e$ à l'intérieur de l'enceinte permet de distribuer et de pomper les gaz en relation de la zone d'excitation, en un ou plusieurs emplacements, comme cela ressort de la **fig. 3**. Une telle configuration permet également de disposer d'une structure d'excitation pouvant être adaptée à la forme des produits $11$ à traiter (plan ou cylindrique). Il apparaît, en particulier, possible de placer l'excitateur $e$ à la distance souhaitée du produit.

Pour privilégier la propagation des micro-ondes en dehors de la zone d'excitation $A$, il faut que, dans chaque triplet, le premier applicateur $p_1$ et le second applicateur $p_2$ soient suffisamment proches l'un de l'autre, afin que la propagation de la puissance maximale ait lieu préférentiellement entre-eux. D'une manière générale, la distance entre les applicateurs $p_1$, $p_2$ de chaque triplet doit être du même ordre et, si possible, égale ou inférieure à la distance entre chaque applicateur $p_1$, $p_2$ et l'excitateur $e$.

Dans l'exemple illustré, il est à noter que la source micro-onde $20$ est reliée aux premiers applicateurs $p_1$. Bien entendu, il peut être envisagé de raccorder directement la source micro-onde $20$ aux seconds applicateurs $p_2$, voire aux applicateurs d'excitation $e$, la propagation de la puissance maximale restant toujours assurée par les applicateurs $p_1$, $p_2$. De préférence, la source micro-onde $20$ est reliée à l'un des deux applicateurs $p_1$, $p_2$ pour éviter une excitation préférentielle à l'extrémité de l'applicateur d'excitation $e$ et pour obtenir une uniformité de la production du plasma tout le long de l'excitateur. Il est à considérer, également, que l'un ou l'autre des applicateurs $p_1$, $p_2$ peuvent être constitués par une partie de la paroi de l'enceinte $7$.

Par ailleurs, dans le cas où les applicateurs d'excitation $e$ sont réalisés par l'intermédiaire d'aimants permanents, des structures variées d'aimants permanents peuvent être utilisées. Ainsi, il peut être envisagé d'utiliser, par exemple, un applicateur magnétique du type filaire à aimantation diamétrale continue **(fig. 3)**, ou un applicateur filaire avec une structure magnétique alternée utilisant des aimants à aimantation axiale **(fig. 5)**. D'une manière générale, l'excitateur $e$ et les applicateurs $p_1$, $p_2$ peuvent présenter des formes et des sections quelconques et peuvent, si nécessaire, être refroidis intérieurement à l'aide de canalisations de circulation d'un fluide de refroidissement aménagé à l'intérieur des excitateurs et/ou des applicateurs.

Il est à noter que les applicateurs et/ou les excitateurs peuvent aussi assurer la distribution de gaz, de photons, d'électrons additionnels, de rayonnements, etc. De même, il peut être avantageux d'entourer les applicateurs $p_1$, $p_2$ par l'intermédiaire d'une enveloppe diélectrique, en vue d'obtenir une isolation électrique ou thermique du dispositif vis-à-vis de l'extérieur ou pour éviter des risques de contamination métallique, voire pour mieux assurer la propagation, sans perte de la puissance micro-onde, le long des applicateurs en présence de plasma.

Le dispositif d'excitation selon l'invention peut être utilisé dans des applications nécessitant un unique triplet d'excitation. Il peut, bien entendu, être utilisé une série de triplets en association, de façon à produire de grandes surfaces de plasma de dimensions et de configurations très variées (planes, cylindriques, tête-bêche, ...) ou pour former, avec le champ magnétique fourni par les applicateurs d'excitation $e$, une structure magnétique multipolaire de confinement, comme celle illustrée à la **fig. 2**. A titre d'exemples non limitatifs, les **fig. 6** à **9** montrent différentes combinaisons dans lesquelles les applicateurs de propagation $p_1$, $p_2$ ou les excitateurs $e$ peuvent être communs à des dispositifs adjacents ou consécutifs. Dans tous les cas, la zone de propagation $P$ et la zone d'absorption $A$ doivent être séparées spatialement comme cela a été expliqué ci-dessus.

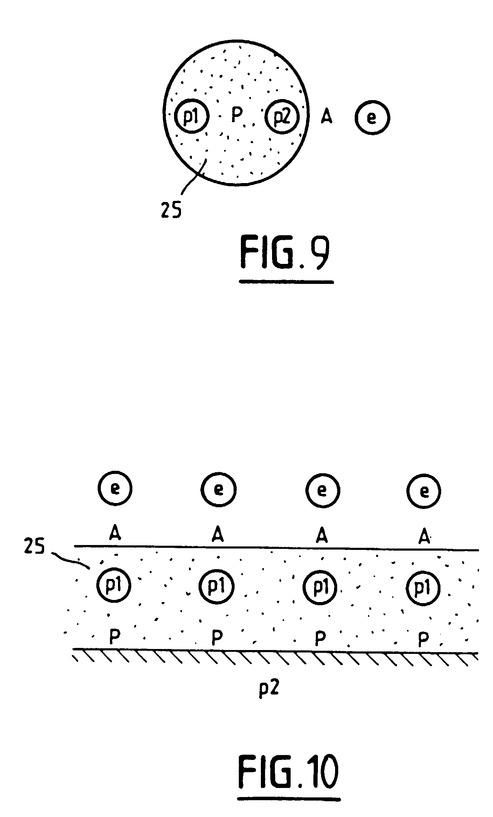

Les **fig. 9** et **10** illustrent une deuxième variante de réalisation du dispositif d'excitation selon l'invention, destiné à être mis en oeuvre pour des hautes pressions ou pour une forte puissance micro-onde.

A haute pression ou à forte puissance micro-onde, pour éviter le claquage ou l'allumage du plasma dans la zone privilégiée de propagation **P** où le champ électrique est plus élevé, il est proposé de remplir cette zone de propagation **P** avec un matériau diélectrique **25** à faible perte. Le claquage a alors lieu dans la zone dite d'excitation **A**. A haute pression où la résonance cyclotronique électronique n'est plus possible en raison des collisions élastiques sur les neutres trop fréquentes, le champ magnétique perd son efficacité et les applicateurs d'excitation **e** peuvent alors se réduire à des simples applicateurs filaires similaires aux applicateurs de propagation.

Parmi les avantages apportés par l'invention, il faut citer ceux permettant de remédier aux problèmes posés par les techniques antérieures et, en particulier, à tous les problèmes liés à la propagation des micro-ondes le long du dispositif d'excitation du plasma. Dans l'invention, l'utilisation de trois applicateurs filaires permet de dissocier spatialement la propagation des micro-ondes et l'excitation du plasma, évitant ainsi les ruptures d'impédances liées à des inhomogénéités locales importantes du champ magnétique et donc du plasma. En outre, l'invention permet une souplesse d'utilisation élargie, en particulier, pour le choix des configurations de réacteur, des structures magnétiques et pour le domaine de pression accessible (typiquement de $10^{-3}$ Pascal à $10^3$ Pascals ou plus). Un autre avantage décisif est l'efficacité du dispositif puisqu'il est possible d'augmenter, sans limitations purement physiques, la puissance micro-onde se propageant le long des applicateurs de propagation et donc d'accroître simultanément la densité du plasma. Un autre avantage de l'invention réside dans le fait qu'il est possible d'augmenter la vitesse de pompage proportionnellement aux dimensions du produit **11** à traiter, tel que cela ressort de l'exemple illustré à la **fig. 3**. Par ailleurs, il peut être obtenu un très bon rendement d'excitation par l'utilisation d'aimants placés dans le volume intérieur de l'enceinte et qui peuvent constituer chacun ou avec leur voisin, des magnétrons tridimensionnels.

## Revendications

1. Dispositif de distribution d'une puissance micro-onde pour l'excitation d'un plasma à l'intérieur d'une enceinte, le dispositif comportant :

   - une source **(20)** d'énergie micro-onde,
   - au moins un premier applicateur **(p₁)** d'une énergie micro-onde **(21)**,
   - et au moins un excitateur **(e)** du plasma de forme filaire, placé à distance du premier applicateur **(p₁)** micro-onde pour délimiter entre-eux une zone d'absorption **(A)**, les électrons étant accélérés par le champ micro-onde selon des trajectoires déterminées **(5)**,

   caractérisé en ce que le dispositif de distribution comporte au moins un second applicateur **(p₂)** de l'énergie micro-onde pour former, avec un premier applicateur **(p₁)** et un excitateur **(e)**, au moins un triplet d'excitation dans lequel, d'une part, le premier applicateur **(p₁)** et le second applicateur **(p₂)** sont montés sensiblement parallèlement l'un à l'autre en étant écartés d'une distance donnée pour délimiter entre-eux une zone de propagation **(P)** de l'énergie micro-onde et, d'autre part, l'excitateur **(e)** est disposé à l'intérieur de l'enceinte **(7)** en étant placé par rapport aux premier **(p₁)** et second **(p₂)** applicateurs, de manière que les trajectoires **(5)** des électrons ne traversent pas la zone de propagation **(P)** permettant d'obtenir une dissociation entre les zones de propagation (P) et d'absorption **(A)**.

2. Dispositif selon la revendication 1, caractérisé en ce que les premier **(p₁)** et second **(p₂)** applicateurs d'un même triplet sont placés de manière que la distance les séparant soit égale ou inférieure à la distance entre chacun des applicateurs **(p₁, p₂)** et l'excitateur **(e)** associé.

3. Dispositif selon la revendication 1, caractérisé en ce que l'excitateur de plasma **(e)** est un élément d'application d'un champ magnétique.

4. Dispositif selon la revendication 3, caractérisé en ce que l'excitateur **(e)** de plasma est un élément d'application d'un champ magnétique à la fréquence de résonance cyclotronique électronique.

5. Dispositif selon la revendication 1, caractérisé en ce que la zone de propagation **(P)** de l'énergie micro-onde, délimitée entre le premier **(p₁)** et le second **(p₂)** applicateurs, est remplie d'un matériau diélectrique pour éviter le claquage du plasma dans cette zone, pour des hautes pressions ou à forte puissance micro-onde, l'excitateur de plasma **(e)** étant alors formé par un applicateur filaire similaire aux applicateurs de propagation **(p₁, p₂)**.

6. Dispositif selon la revendication 1, caractérisé en ce que les applicateurs **(p₁, p₂)** sont constitués chacun par un élément filaire.

7. Dispositif selon la revendication 1, caractérisé en ce qu'au moins l'un des applicateurs **(p₁, p₂)** d'un triplet est constitué par une paroi d'une enceinte étanche.

8. Dispositif selon les revendications 1 et 6, caractérisé en ce que la source d'énergie micro-onde **(20)** est reliée à l'un quelconque d'un élément filaire **(p₁, p₂)** constitutif d'un triplet d'excitation.

9. Dispositif selon la revendication 1, caractérisé en ce que les deux applicateurs **(p₁, p₂)** sont montés à l'intérieur de l'enceinte **(7)**.

10. Dispositif selon la revendication 1, caractérisé en ce que l'excitateur **(e)** est monté sensiblement parallèlement aux applicateurs **(p₁, p₂)**.

11. Dispositif selon la revendication 1, caractérisé en ce que l'excitateur **(e)** est placé perpendiculairement par rapport aux applicateurs **(p₁, p₂)**.

12. Dispositif selon la revendication 1, caractérisé en ce que l'excitateur **(e)** possède une longueur finie inférieure à la dimension de l'enceinte **(7)**, de façon à laisser subsister entre l'enceinte et au moins une partie terminale de l'excitateur, une zone de non excitation.

13. Dispositif selon la revendication 1, caractérisé en ce que l'excitateur **(e)** du plasma comporte une structure aimantée à aimantation radiale, axiale ou diamétrale, continue ou alternée.

14. Dispositif selon la revendication 1, caractérisé en ce qu'il comporte une série d'excitateurs **(e)** placés entre-eux de manière à former une structure magnétique multipolaire.

15. Machine de production d'un plasma du type comprenant une enceinte étanche **(7)** raccordée à au moins un dispositif de pompage **(9)** et à un dispositif **(8)** d'apport d'un milieu gazeux pour maintenir une pression déterminée dans l'enceinte, caractérisée en ce qu'elle comporte au moins un dispositif conforme à la revendication 1.

**Patentansprüche**

1. Vorrichtung zur Verteilung von Mikrowellenleistung zur Anregung eines Plasmas im Inneren eines Behälters, die aufweist:

   - eine Quelle (20) für Mikrowellenenergie,
   - mindestens eine erste Zufuhreinrichtung (p₁) zur Zufuhr von Mikrowellenenergie (21) und
   - mindestens eine drahtförmige Anregungseinrichtung (e) für das Plasma, die von der ersten Zufuhreinrichtung (p₁) für Mikrowellen beabstandet angeordnet ist, um so dazwischen einen Absorptionsbereich (A) vorzugeben, wobei die Elektronen durch das Mikrowellenfeld auf bestimmte Bahnen (5) beschleunigt werden,

dadurch gekennzeichnet, daß sie mindestens eine zweite Zufuhreinrichtung (p₂) zur Zufuhr von Mikrowellenenergie umfaßt, die mit der ersten Zufuhreinrichtung (p₁) und einer Anregungseinrichtung (e) mindestens ein Anregungs-Tripel bildet, in dem zum einen die erste Zufuhreinrichtung (p₁) und die zweite Zufuhreinrichtung (p₂) im wesentlichen parallel zueinander angeordnet und in einem bestimmten Abstand voneinander beabstandet sind, um zwischen ihnen einen Ausbreitungsbereich (P) für die Mikrowellenenergie vorzugeben, und zum anderen die Anregungseinrichtung (e) im Inneren des Behälters (7) vorgesehen ist, wobei sie bezüglich der ersten Zufuhreinrichtung (p₁) und der zweiten Zufuhreinrichtung (p₂) so angeordnet ist, daß die Bahnen (5) der Elektronen den Ausbreitungsbereich (P) nicht durchlaufen, wodurch eine Trennung zwischen dem Ausbreitungsbereich (P) und dem Absorptionsbereich (A) erreicht wird.

2. Vorrichtung nach Anspruch 1, dadurch gekennzeichnet, daß die erste Zufuhreinrichtung (p₁) und die zweite Zufuhreinrichtung (p₂) ein und desselben Tripels so angeordnet sind, daß der Abstand zwischen ihnen kleiner oder gleich dem Abstand zwischen jeder der Zufuhreinrichtungen (p₁, p₂) und der zugehörigen Anregungseinrichtung (e) ist.

3. Vorrichtung nach Anspruch 1, dadurch gekennzeichnet, daß die Anregungseinrichtung (e) für das Plasma eine Einrichtung zum Anlegen eines Magnetfeldes ist.

4. Vorrichtung nach Anspruch 3, dadurch gekennzeichnet, daß die Anregungseinrichtung (e) für das Plasma eine Einrichtung zum Anlegen eines Magnetfeldes mit der Zyklotronresonanzfrequenz der Elektronen ist.

5. Vorrichtung nach Anspruch 1, dadurch gekennzeichnet, daß der Ausbreitungsbereich (P) der Mikrowellenenergie, der zwischen der ersten Zufuhreinrichtung (p₁) und der zweiten Zufuhreinrichtung (p₂) vorgegeben ist, mit einem dielektrischen Material gefüllt ist, damit bei hohen Drücken oder hoher Mikrowellenleistung kein Durchschlag des Plasmas in diesem Bereich stattfindet, wobei die Anregungseinrichtung (e) für das Plasma dann durch eine drahtförmige Zufuhreinrichtung gebildet wird, die ähnlich wie die zur Ausbreitung wirksamen Zufuhreinrichtungen (p₁, p₂) ausgebildet ist.

6. Vorrichtung nach Anspruch 1, dadurch gekennzeichnet, daß die Zufuhreinrichtungen (p₁, p₂) jeweils von einem drahtförmigen Element gebildet werden.

7. Vorrichtung nach Anspruch 1, dadurch gekennzeichnet, daß mindestens eine der Zufuhreinrichtungen ($p_1$, $p_2$) eines Tripels durch eine Wand eines dichten Behälters gebildet wird.

8. Vorrichtung nach den Ansprüchen 1 und 6, dadurch gekennzeichnet, daß die Quelle (20) für Mikrowellenenergie mit einem der drahtförmigen Elemente ($p_1$, $p_2$) verbunden ist, mit denen ein Anregungs-Tripel aufgebaut ist.

9. Vorrichtung nach Anspruch 1, dadurch gekennzeichnet, daß die beiden Zufuhreinrichtungen ($p_1$, $p_2$) im Inneren des Behälters (7) angeordnet sind.

10. Vorrichtung nach Anspruch 1, dadurch gekennzeichnet, daß die Anregungseinrichtung ($\underline{e}$) im wesentlichen parallel zu den Zufuhreinrichtungen ($p_1$, $p_2$) angeordnet ist.

11. Vorrichtung nach Anspruch 1, dadurch gekennzeichnet, daß die Anregungseinrichtung ($\underline{e}$) senkrecht zu den Zufuhreinrichtungen ($p_1$, $p_2$) angeordnet ist.

12. Vorrichtung nach Anspruch 1, dadurch gekennzeichnet, daß die Anregungseinrichtung ($\underline{e}$) eine begrenzte Länge besitzt, die kleiner als die Größe des Behälters (7) ist, damit zwischen dem Behälter und mindestens einem Endabschnitt der Anregungseinrichtung ein anregungsfreier Bereich bestehen bleibt.

13. Vorrichtung nach Anspruch 1, dadurch gekennzeichnet, daß die Anregungseinrichtung ($\underline{e}$) für das Plasma eine magnetische Struktur mit radialer, axialer oder diametraler Dauer- oder Wechselmagnetisierung aufweist.

14. Vorrichtung nach Anspruch 1, dadurch gekennzeichnet, daß sie eine Reihe von Anregungseinrichtungen ($\underline{e}$) umfaßt, die so zueinander angeordnet sind, daß sie eine mehrpolige magnetische Struktur bilden.

15. Plasmaerzeugungsvorrichtung mit einem dichten Behälter (7), der mit mindestens einer Pumpvorrichtung (9) und mit einer Zufuhrvorrichtung (8) zur Zufuhr eines gasförmigen Mediums verbunden ist, um einen bestimmten Druck im Behälter aufrechtzuerhalten, dadurch gekennzeichnet, daß sie mindestens eine Vorrichtung gemäß Anspruch 1 aufweist.

**Claims**

1. A distribution device for distributing microwave power to excite a plasma inside an enclosure, the device comprising:

- a source (20) of microwave energy;
- at least one first applicator ($p_1$) of microwave energy (21); and
- at least one wire-shaped plasma exciter ($\underline{e}$) placed at a distance from the first microwave applicator ($p_1$) to define between them an absorption zone (A), electrons being accelerated by the microwave field along determined trajectories (5);

  characterized in that the distribution device includes at least one second applicator ($p_2$) of microwave energy to co-operate with a first applicator ($p_1$) and an exciter ($\underline{e}$) to form at least one excitation triplet in which firstly the first applicator ($p_1$) and the second applicator ($p_2$) are mounted substantially parallel to each other and are spaced apart by a given distance to define between them a propagation zone (P) for microwave energy, and secondly the exciter ($\underline{e}$) is disposed inside the enclosure (7) by being placed relative to the first and second applicators ($p_1$, $p_2$) in such a manner that the trajectories (5) of the electrons do not cross the propagation zone (P), thereby dissociating the propagation zone (P) and the absorption zone (A).

2. A device according to claim 1, characterized in that the first and second applicators ($p_1$, $p_2$) of the same triplet are placed in such a manner that the distance between them is equal to or less than the distance between each of the applicators ($p_1$, $p_2$) and the associated exciter ($\underline{e}$).

3. A device according to claim 1, characterized in that the plasma exciter ($\underline{e}$) is an element for applying a magnetic field.

4. A device according to claim 3, characterized in that the plasma exciter ($\underline{e}$) is an element for applying a magnetic field at the electron cyclotron resonance frequency.

5. A device according to claim 1, characterized in that the propagation zone (P) for microwave energy defined between the first and second applicators ($p_1$, $p_2$) is filled with a dielectric material to prevent the plasma discharging in said zone at high pressures or at high microwave powers, the plasma exciter ($\underline{e}$) thus being formed by a wire applicator similar to propagation applicators ($p_1$, $p_2$).

6. A device according to claim 1, characterized in that each of the applicators ($p_1$, $p_2$) is constituted by a wire element.

7. A device according to claim 1, characterized in that at least one of the applicators ($p_1$, $p_2$) of a triplet is constituted by a wall of a sealed enclosure.

8. A device according to claims 1 and 6, characterized in that the microwave energy source (20) is connected to any of the wire elements ($p_1$, $p_2$) constituting an excitation triplet.

9. A device according to claim 1, characterized in that both applicators ($p_1$, $p_2$) are mounted inside the enclosure (7).

10. A device according to claim 1, characterized in that the exciter ($e$) is mounted substantially parallel to the applicators ($p_1$, $p_2$).

11. A device according to claim 1, characterized in that the exciter (e) is placed perpendicularly relative to the applicators ($p_1$, $p_2$).

12. A device according to claim 1, characterized in that the exciter ($e$) is of finite length shorter than the size of the enclosure (7) so as to leave a non-excitation zone between the enclosure and at least one end portion of the exciter.

13. A device according to claim 1, characterized in that the plasma exciter ($e$) has a structure that is magnetized with magnetization that is radial, axial or diametral, continuous or alternating.

14. A deice according to claim 1, characterized in that it includes a series of exciters ($e$) placed relative to one another in such a manner as to form a multipolar magnetic structure.

15. A plasma production machine of the type comprising a sealed enclosure (7) connected to at least one pumping device (9) and to a device (8) for feeding a gaseous medium so as to maintain a determined pressure inside the enclosure, the machine being characterized in that it includes at least one device according to claim 1.

**FIG.1**

**FIG.4**

**FIG.2**

**FIG.3**

FIG.5

FIG.6

FIG.7

FIG.8

FIG.9

FIG.10